# FASCICULE DE BREVET EUROPEEN

(11) **EP 1 628 308 B1**
(45) Date de publication et mention de la délivrance du brevet: **25.06.2008**
(21) Numéro de dépôt: 05107536.4
(22) Date de dépôt: 16.08.2005
(51) Int. Cl.: G11C 5/14

(54) **Dispositif d'aiguillage d'au moins deux tensions, circuit électronique et mémoire correspondants**
Weichenanordnung für mindestens zwei Spannungen, elektronische Schaltung und entsprechende Speicherschaltung
Switch arrangement for at least two tensions, corresponding circuit and memory

(30) Priorité: 17.08.2004 FR 0408938
(43) Date de publication de la demande: 22.02.2006
(73) Titulaire: ATMEL NANTES SA, 44306 Nantes Cédex 3 (FR)
(72) Inventeur: Coloma, Bernard, 44300 Nantes (FR); Husson, Olivier, 44600 Saint Nazaire (FR)
(74) Mandataire: Bioret, Ludovic

(56) Documents cités:
- EP-A- 0 627 807
- EP-A- 0 782 268
- US-A- 4 038 564
- US-A- 6 133 777
- US-A1- 2003 214 343
- US-B1- 6 348 831

## Description

### 1. Domaine de l'invention

Le domaine de l'invention est celui de l'électronique, et plus précisément celui de l'aiguillage de signaux, portant chacun une tension de valeur différente, vers une sortie unique.

Plus précisément encore, l'invention concerne une technique d'aiguillage de tensions mettant en oeuvre des transistors de type MOS (de l'anglais « Metal Oxide Semiconductor » pour « semi-conducteur à oxyde de métal »).

L'invention peut notamment être mise en oeuvre dans tout circuit électronique nécessitant l'utilisation de plusieurs alimentations, tel que par exemple les mémoires Flash ou EEPROM (de l'anglais « Electrically Erasable Programmable Read Only Memory » pour «mémoire morte effaçable et programmable électriquement »), etc.

### 2. Art antérieur

Dans la conception de certains types de circuits électroniques, par exemple les mémoires Flash ou les mémoires EEPROM, plusieurs tensions d'alimentation sont utilisées.

Ainsi, une première tension d'alimentation VCC, de l'ordre de 1,8V, alimente les transistors basse tension, tandis qu'une tension d'alimentation plus élevée alimente les transistors haute tension.

Un dispositif d'aiguillage de tensions, permettant de multiplexer des tensions d'alimentations de valeurs différentes vers une sortie unique en fonction de commandes appliquées sur un circuit de contrôle, est alors nécessaire.

Selon l'art antérieur, plusieurs techniques d'aiguillage de tensions à base de transistors ont été proposées. Le document US 4 038 564 présente un circuit de selection d'une tension, à partir de transistors PMOS montés en série, et de transistors NMOS montés en série.

Cependant, la plupart de ces techniques de l'art antérieur présentent l'inconvénient de générer des courants de fuite ou de court-circuit entre les différentes alimentations, dus notamment à la polarisation des diodes en direct dans le caisson des transistors, ou à la conduction inverse des transistors. Ces techniques ne permettent donc pas d'aiguiller de manière fiable les différentes tensions.

Une autre technique à base de transistors NMOS a été proposée, permettant d'éviter les courants de fuite entre les différentes broches des transistors.

Cependant, un inconvénient majeur de cette technique de l'art antérieur est qu'elle nécessite l'utilisation de systèmes de compensation de la tension de seuil V_{T} des transistors, permettant d'éviter que la tension d'alimentation à aiguiller ne chute de la tension de seuil V_{T}.

Une telle technique est donc coûteuse en termes de ressources, puisqu'elle nécessite l'ajout d'un système de compensation de la tension de seuil, et complexe.

### 3. Objectifs de l'invention

L'invention a notamment pour objectif de pallier ces inconvénients de l'art antérieur.

Plus précisément, un objectif de l'invention est de fournir une technique d'aiguillage multi-tensions permettant d'aiguiller au moins deux tensions d'alimentation distinctes vers une sortie unique, de manière simple et efficace.

L'invention a notamment pour objectif de proposer une telle technique qui soit peu coûteuse en termes de ressources, c'est-à-dire en nombre de transistors, et simple à implémenter.

Un autre objectif de l'invention est de fournir une telle technique ne générant pas, ou peu, de courants de fuite dus à une mauvaise polarisation des transistors.

Encore un autre objectif de l'invention est de proposer une telle technique ne générant pas, ou peu, de courants de court-circuit entre les différentes tensions d'alimentation.

L'invention a encore pour objectif de fournir une telle technique qui soit moins complexe et qui présente de meilleures performances que les techniques de l'art antérieur.

### 4. Caractéristiques essentielles de l'invention

Ces objectifs, ainsi que d'autres qui apparaîtront par la suite, sont atteints à l'aide d'un dispositif d'aiguillage de tensions comprenant au moins deux branches permettant chacune d'aiguiller une tension provenant d'une alimentation vers une sortie unique.

Selon l'invention, chacune des branches d'un tel dispositif comprend au moins deux transistors, dont au moins un transistor de protection assurant une double fonction de :
- protection de l'alimentation ; et
- gestion d'au moins un courant de fuite, généré entre au moins deux broches du transistor de protection.

L'invention propose ainsi d'ajouter à chacune des branches pouvant aiguiller une tension au moins deux transistors en série, dont au moins un transistor de protection, permettant à la fois de protéger l'alimentation de la branche sélectionnée de tous courants de court-circuit provenant de la sortie de l'aiguilleur (dite sortie unique), et d'éviter les courants de fuite dus à la polarisation d'une diode en direct dans le caisson.

Ainsi, l'invention propose d'aiguiller de manière simple, efficace et modulable une tension parmi au moins deux vers une sortie unique, tout en contrôlant les courants générés ente la sortie de l'aiguilleur de tension et les différentes tensions d'alimentation, ce qui n'était pas prévu dans les systèmes de l'art antérieur.

On remarque que la branche sélectionnée correspond ici et dans toute la suite du document à la branche connectée à la sortie de l'aiguilleur et portant la tension à aiguiller.

Avantageusement, lesdits transistors sont de type PMOS.

Ainsi, l'invention repose sur une approche tout à fait nouvelle et inventive de l'aiguillage de tensions dans un système multi-tensions. En effet, selon les techniques de l'art antérieur, les transistors de type PMOS n'étaient pas utilisés dans les systèmes d'aiguillage de tensions, du fait du problème de conduction inverse de ces transistors, généré lorsque la tension au niveau du drain du transistor PMOS monte à une tension supérieure à la tension au niveau de la grille du transistor.

De manière préférentielle, la protection de l'alimentation est assurée par le positionnement du ou des transistor(s) de protection à l'extrémité de la branche, connectée à la sortie unique.

Le drain des transistors de protection est alors relié à la sortie de l'aiguilleur, dite sortie unique.

Ainsi, lorsqu'une branche de l'aiguilleur est sélectionnée, la grille de chacun des transistors de protection des autres branches est mise au même potentiel que la branche sélectionnée, c'est-à-dire à la tension provenant de l'alimentation connectée à la première extrémité de la branche sélectionnée, si ce potentiel est supérieur à la tension d'alimentation du circuit (VCC). Dans ce cas, le transistor de protection de chacune des branches non sélectionnées, situé à la seconde extrémité de chacune des branches, est alors bloqué.

La grille de chacun des transistors de protection PMOS se trouve alors au même potentiel que le drain de ces transistors, le drain de ces transistors étant connecté à la sortie de l'aiguilleur, et il ne peut pas y avoir de courant de court-circuit entre les différentes alimentations.

Le dispositif de l'invention fonctionne alors de manière peu complexe en bloquant les transistors de certaines branches en fonction de la branche sélectionnée. Plus précisément, lorsqu'une branche est sélectionnée, certains transistors PMOS des autres branches sont dans un état bloqué.

De façon avantageuse, la gestion des courants de fuite est réalisée par une liaison entre le caisson du transistor de protection et la sortie unique de l'aiguilleur.

On supprime ainsi, au moins en partie, les courants de fuite dus à la polarisation d'une diode en direct dans le caisson en reliant le caisson des transistors de protection sur la sortie de l'aiguilleur et non sur l'alimentation de la branche, comme cela est prévu dans les systèmes de l'art antérieur.

Préférentiellement, le dispositif comprenant des moyens de sélection d'une des branches (portant la tension à aiguiller vers la sortie unique), au moins une des branches comprend des moyens de réduction d'un courant de court-circuit généré lors de la sélection.

Ces moyens de réduction comprennent notamment au moins un système de retard, formé d'au moins deux inverseurs montés en série.

Ainsi, la sélection d'une branche et/ou la désélection des autres branches peuvent être retardées d'un certain délai, de l'ordre de quelques nanosecondes. Ce système de retard permet d'éviter le passage d'un courant entre une nouvelle branche sélectionnée et la branche précédemment sélectionnée, en cours de désélection.

Le système de retard permet ainsi d'attendre que le transistor de la branche précédemment sélectionnée soit complètement désélectionné (c'est-à-dire bloqué) avant de valider la nouvelle branche.

Selon un mode de réalisation avantageux de l'invention, au moins une branche, dite branche de premier type, comprend deux bascules, deux systèmes de retard, un inverseur et au moins deux transistors haute tension de type PMOS en série, et au moins une branche, dite branche de deuxième type, comprend un inverseur et au moins trois transistors haute tension de type PMOS en série, au moins deux de ces transistors assurant la gestion des courants de fuite.

La tension aiguillée par la branche de deuxième type provient d'une alimentation basse tension (VCC).

Ainsi, chacune des branches comprend des moyens de protection de l'alimentation, de gestion des courants de fuite, et de réduction d'un courant de court-circuit.

L'invention concerne également les mémoires comprenant un dispositif d'aiguillage de tensions tel que décrit précédemment.

L'invention concerne encore un circuit électronique d'aiguillage de tensions correspondant.

### 5. Liste des figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- la figure 1A illustre le principe général d'un dispositif d'aiguillage multi-tensions selon l'invention et la figure 1B présente un schéma du circuit électronique correspondant ;
- la figure 2 présente le schéma interne des bascules du circuit électronique de la figure 1B ;
- les figures 3 et 4 présentent les schémas internes des systèmes de retard du circuit électronique de la figure 1B ;
- les figures 5A à 5F présentent les courbes représentatives de la tension véhiculée par les différents signaux du circuit électronique de la figure 1B, en fonction du temps.

### 6. Description d'un mode de réalisation de l'invention

Le principe général de l'invention repose sur l'utilisation, dans chacune des branches aiguillant une tension d'alimentation vers la sortie unique, de transistors PMOS haute tension montés en série.

Selon l'invention, au moins un de ces transistors, dit transistor de protection, permet de protéger l'alimentation de la branche à laquelle il appartient des courants de court-circuit et de supprimer, ou à tout le moins de réduire, les courants de fuite générés par une mauvaise polarisation du transistor, en connectant le caisson de chacun de ces transistors de protection à la sortie de l'aiguilleur.

Un système de retard peut également être ajouté dans les différentes branches, de sorte à éviter les courants de court-circuit lors de la sélection et/ou de la désélection des différentes branches.

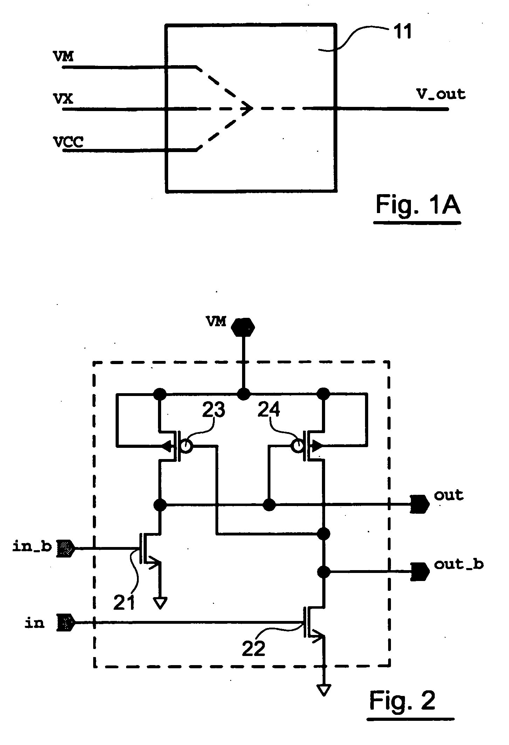

On présente, en relation avec la figure 1A, le principe général du dispositif d'aiguillage de tensions selon l'invention.

Un tel dispositif 11 comprend au moins deux signaux d'entrée portant une tension d'alimentation, et un seul signal de sortie, portant la tension d'alimentation de la branche sélectionnée.

Par souci de simplification, on se limite ici, et dans toute la suite du document, à décrire le cas d'un système d'aiguillage multi-tensions comprenant trois tensions d'alimentation en entrée.

L'Homme du Métier étendra sans difficulté cet enseignement à tous types de système d'aiguillage multi-tensions comprenant plus de trois tensions d'alimentation en entrée.

On trouve ainsi, par exemple, trois signaux d'alimentation en entrée du dispositif d'aiguillage de tension 11 :
- un premier signal VM, provenant d'une alimentation haute tension, par exemple de l'ordre de 15 Volts ;
- un deuxième signal VX, provenant d'une alimentation de tension intermédiaire, par exemple de l'ordre de 3 Volts ;
- un troisième signal VCC, provenant d'une alimentation basse tension alimentant le dispositif, par exemple de l'ordre de 1,8 Volts pour des technologies de l'ordre de 0,18 micron.

En sortie, le dispositif 11 d'aiguillage de tension délivre un seul signal V_out qui est sensiblement égal soit à VM, soit à VX, soit encore à VCC, en fonction de signaux de contrôle agissant sur le dispositif 11.

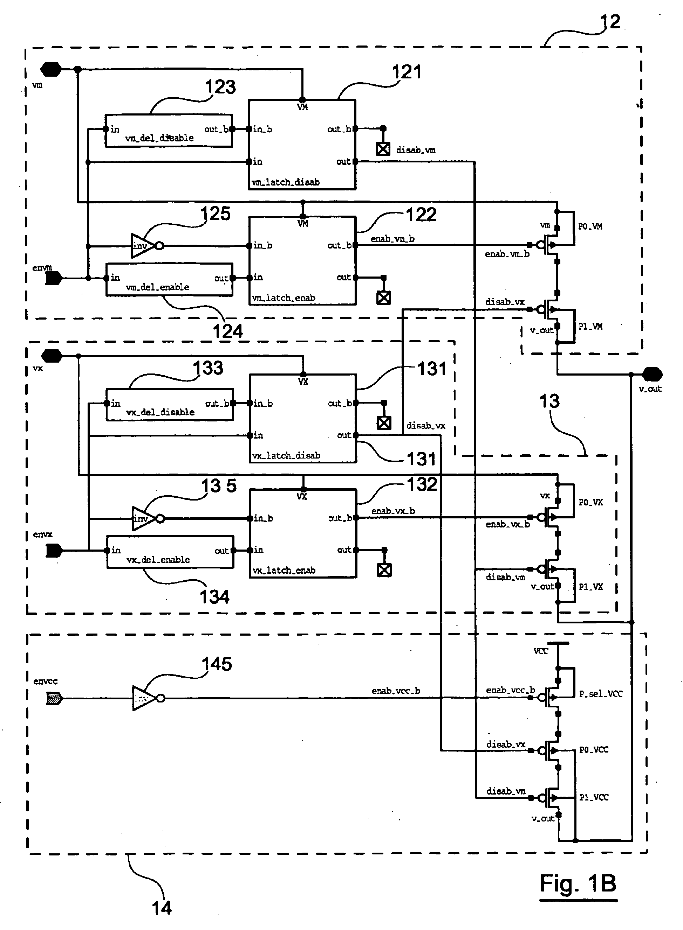

Le figure 1B illustre plus précisément le fonctionnement de l'invention dans un circuit électronique d'aiguillage multi-tensions.

Comme précisé précédemment en relation avec la figure 1A, un tel circuit d'aiguillage multi-tensions comprend trois signaux d'alimentation en entrée (VM, VX et VCC, où VM porte une tension d'alimentation de l'ordre de 15V, VX de l'ordre de 3V, et VCC de l'ordre de 1,8V) et un signal de sortie V_out correspondant soit à la tension VM, soit à VX, soit à VCC.

Le circuit d'aiguillage multi-tensions comprend également trois signaux de contrôle *envm, envx* et *envcc* validant l'aiguillage des différentes branches.

Ces signaux de contrôle, actifs sur le niveau haut (c'est-à-dire au potentiel VCC, la tension VCC alimentant tout le circuit électronique), permettent de sélectionner la branche portant la tension d'alimentation à aiguiller.

Le tableau suivant précise ainsi la valeur de la tension du signal de sortie V_out en fonction de l'état des signaux de contrôle, un niveau haut étant codé par un '1' et un niveau bas étant codé par un '0' :

| ***envm*** | ***envx*** | ***envcc*** | **V_out** |
|---|---|---|---|
| 1 | 0 | 0 | VM |
| 0 | 1 | 0 | VX |
| 0 | 0 | 1 | VCC |

Ainsi, le circuit électronique selon l'invention peut se décomposer en trois branches permettant chacune de transférer une tension vers la sortie de l'aiguilleur V_out :
- une première branche 12 permettant d'aiguiller la tension VM vers la sortie unique V_out ;
- une deuxième branche 13 permettant d'aiguiller la tension VX vers la sortie unique V_out ; et
- une troisième branche 14 permettant d'aiguiller la tension VCC vers la sortie unique V_out.

Chaque branche comprend au moins deux transistors PMOS haute tension en série, le drain d'un transistor étant connecté à la source du transistor suivant, et le drain du dernier transistor de la série de transistors étant connecté à la sortie unique de l'aiguilleur (signal V_out).

Selon l'invention, le caisson du dernier transistor, dit transistor de protection, est également relié à la sortie de l'aiguilleur.

Un tel transistor de protection positionné à l'extrémité de chacune des branches connectée à la sortie de l'aiguilleur permet à la fois de protéger l'alimentation contre les courants de court-circuit provenant de la sortie de l'aiguilleur et de diminuer les courants de fuite provenant d'une mauvaise polarisation du transistor.

Les branches transportant les différentes tensions ne comprennent pas toujours le même nombre de transistors, et peuvent comprendre plusieurs transistors de protection en série.

Ainsi, selon l'invention, on distingue deux types de branches :
- un premier type de branche aiguillant une tension différente de la tension d'alimentation du circuit, c'est-à-dire différente de VCC ;
- un deuxième type de branche aiguillant la tension d'alimentation du circuit, c'est-à-dire VCC.

Ainsi, comme illustré en figure 1B, la première branche 12 et la deuxième branche 13 présentent une structure identique, et appartiennent au premier type de branche.

Plus précisément, la première branche 12 (respectivement la deuxième branche 13) comprend :
- deux bascules haute tension *vm_latch_disab* 121 et *vm_latch_enab* 122 (respectivement *vx_latch_disab* 131 et *vx_latch_enab* 132) permettant de convertir la tension portée par les signaux de contrôle au niveau haut (VCC) à la tension d'alimentation VM (respectivement VX) ;
- deux systèmes de retard *vm_del_disable* 123 et *vm_del_enable* 124 (respectivement *vx_del_disable* 133 et *vx_del_enable* 134) permettant d'éviter le passage d'un courant entre une nouvelle banche sélectionnée et la branche précédemment sélectionnée, en cours de désélection ;
- un inverseur 125 (respectivement 135) ; et
- deux transistors PMOS haute tension en série P0_VM et P1_VM (respectivement P0_VX et P1_VX), dont un transistor de protection P1_VM (respectivement P1_VX), permettant de protéger l'alimentation et de diminuer les courants de fuite.

Le drain du transistor P0_VM (respectivement P0_VX) est alors connecté à la source du transistor P1_VM (respectivement P1_VX), et le drain du transistor P1_VM (respectivement P1_VX), ainsi que son caisson, sont connectés à la sortie de l'aiguilleur.

Le signal d'alimentation VM (respectivement VX) alimente chacune des deux bascules haute tension *vm_latch_disab* 121 et *vm_latch_enab* 122 (respectivement *vx_latch_disab* 131 et *vx_latch_enab* 132). Ce signal est également relié à la source du transistor P0_VM (respectivement P0_VX), elle-même connectée au caisson du transistor P0_VM (respectivement P0_VX). Le signal de contrôle *envm* (respectivement *envx*) est connecté :
- à une première entrée de la bascule *vm_latch_disab* 121 (respectivement *vx_latch_disab* 131) par l'intermédiaire du système de retard *vm_del_disable* 123 (respectivement *vx_del_disable* 133) ;
- à une deuxième entrée de la bascule *vm_latch_disab* 121 (respectivement *vx_latch_disab* 131) ;
- à une première entrée de la bascule *vm_latch_enab* 122 (respectivement *vx_latch_enab* 132) par l'intermédiaire de l'inverseur 125 (respectivement 135) ; et
- à une deuxième entrée de la bascule *vm_latch_enab* 122 (respectivement *vx_latch_enab* 132) par l'intermédiaire du système de retard *vm_del_enable* 124 (respectivement *vx_del_enable* 134).

La sortie de la bascule haute tension *vm_latch_disab* 121 (respectivement *vx_latch_disab* 131), notée *disab_vm* (respectivement *disab_vx*) est connectée à la grille d'au moins un transistor de protection de chacune des autres branches, c'est-à-dire à la grille des transistors P1_VX et P1_VCC (respectivement P1_VM et P0_VCC).

La sortie de la bascule haute tension *vm_latch_enab* 122 (respectivement *vx_latch_enab* 132), notée *enab_vm_b* (respectivement *enab_vx_b*), est connectée à la grille du premier transistor de la série de transistors PMOS haute tension de sa branche, c'est-à-dire à P0_VM (respectivement P0_VX).

La troisième branche 14, permettant d'aiguiller la tension d'alimentation du circuit (VCC), est une branche du deuxième type.

Plus précisément, cette troisième branche 14 comprend un inverseur 145 et trois transistors PMOS haute tension en série P_sel_VCC, P0_VCC et P1_VCC, dont deux transistors de protection P0_VCC et P1_VCC permettant de protéger l'alimentation et de diminuer les courants de fuite.

Le signal d'alimentation VCC alimente la source du premier transistor de la série de trois transistors, le transistor P_sel_VCC. Le drain du transistor P_sel_VCC est relié à la source du transistor P0_VCC, le drain du transistor P0_VCC est connecté à la source du transistor P1_VCC, et le drain du transistor P1_VCC est relié à la sortie de l'aiguilleur.

Le caisson du transistor P_sel_VCC est connecté à l'alimentation VCC, et les caissons des transistors P0_VCC et P1_VCC sont connectés à la sortie unique de l'aiguilleur de tension.

Le signal de contrôle *envcc* est connecté à l'inverseur 145. La sortie de l'inverseur 145, notée *enab_vcc_b*, est reliée à la grille du transistor P_sel_VCC.

Ainsi, les signaux de contrôle interne *enab_vm_b, enab_vx_b* et *enab_vcc_b* en sortie des bascules *vm_latch_enab* 122, *vx_latch_enab* 132 et de l'inverseur 145, actifs sur le niveau bas, permettent la conduction des transistors PMOS sur la branche sélectionnée.

Les signaux de contrôle interne *disab_vm* et *disab_vx* en sortie des bascules *vm_latch_disab* 121 et *vx_latch_disab* 122, actifs sur le niveau haut, permettent de bloquer les transistors PMOS des branches non sélectionnées.

Selon les techniques de l'art antérieur, si le caisson d'un transistor PMOS est alimenté par une tension inférieure à la tension au niveau de la source du transistor, alors apparaît un courant de fuite dû à la polarisation d'une diode en direct dans le caisson.

Selon l'invention en revanche, les caissons de type N des transistors PMOS de protection (P1_VM, P1_VX, P0_VCC, P1_VCC) sont connectés à la sortie de l'aiguilleur V_out. Les caissons suivent alors la tension de sortie V_out, et montent à la tension de chaque branche sélectionnée, évitant ainsi les courants de fuite.

La figure 2 illustre plus précisément le fonctionnement des bascules haute tension *vm_latch_disab* 121, *vm_latch_enab* 122, *vx_latch_disab* 131, et *vx_latch_enab* 132.

Ces quatre bascules sont identiques, et présentent une structure classique à base de deux transistors de type NMOS 21 et 22, et deux transistors de type PMOS 23 et 24.

Ces bascules, encore appelées « latch » ou « level shifter » en anglais, permettent notamment de convertir la tension portée par les signaux de contrôle (niveau haut égal à VCC) en la tension d'alimentation de la branche dans laquelle se trouve la bascule.

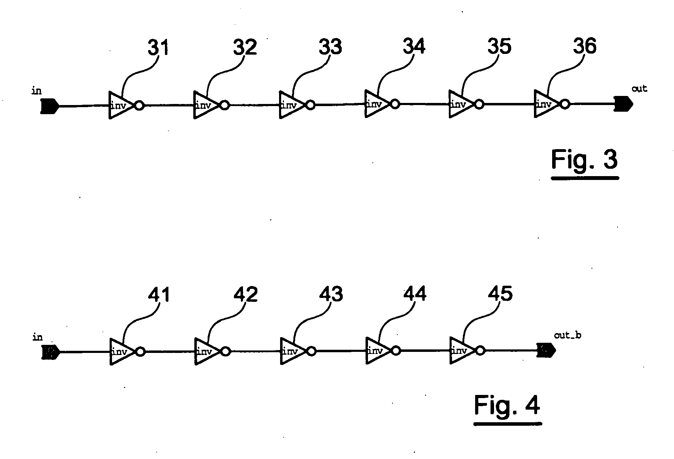

La figure 3 illustre les systèmes de retard *vm_del_enable* 124 de la première branche 12 et *vx_del_enable* 134 de la deuxième branche 13.

Ces deux systèmes de retard présentent une structure identique à base de six inverseurs 31 à 36 montés en série, et permettent de générer un délai de quelques nanosecondes.

On présente dans le tableau ci-après un exemple de réalisation de ces inverseurs 31 à 36, à base de transistors MOS, en fonction des dimensions des canaux N et P :

| | **Largeur du canal N** | **Longueur du canal N** | **Largeur du canal P** | **Longueur du canal P** |
|---|---|---|---|---|
| **31** | 0,42 | 2,8 | 0,42 | 0,18 |
| **32** | 0,42 | 0,18 | 0,42 | 2,8 |
| **33** | 0,42 | 2,8 | 0,42 | 0,18 |
| **34** | 0,42 | 0,18 | 0,42 | 2,8 |
| **35** | 0,42 | 2,8 | 0,42 | 0,18 |
| **36** | 3 | 0,18 | 3 | 0,18 |

La figure 4 illustre les systèmes de retard *vm_del_disable* 123 de la première branche 12 et *vx_del_disable* 133 de la deuxième branche 13.

Ces deux systèmes de retard présentent une structure identique à base de cinq inverseurs 41 à 45 montés en série, et permettent de générer un délai de quelques nanosecondes et d'inverser le signal entrant dans le système de retard.

On présente dans le tableau ci-après un exemple de réalisation de ces inverseurs 41 à 45, à base de transistors MOS, en fonction des dimensions des canaux N et P :

| | **Largeur du canal N** | **Longueur du canal N** | **Largeur du canal P** | **Longueur du canal P** |
|---|---|---|---|---|
| **41** | 0,42 | 0,18 | 0,42 | 3,8 |
| **42** | 0,42 | 3, 8 | 0,42 | 0,18 |
| **43** | 0,42 | 0,18 | 0,42 | 3,8 |
| **44** | 0,42 | 3,8 | 0,42 | 0,18 |
| **45** | 0,3 | 0,18 | 3 | 0,18 |

Les systèmes de retard *vm_del_enable* 124 et *vx_del_enable* 134 permettent de retarder la sélection d'une branche, tandis que les systèmes de retard *vm_del_disable* 123 et *vx_del_disable* 133 permettent de retarder la désélection des autres branches.

Ainsi, ces systèmes de retard permettent d'éviter le passage d'un courant entre une branche nouvellement sélectionnée et la branche précédemment sélectionnée, en cours de désélection.

Le retard permet ainsi d'attendre que le transistor de protection de la branche précédemment sélectionnée soit complètement bloqué avant de valider la nouvelle branche.

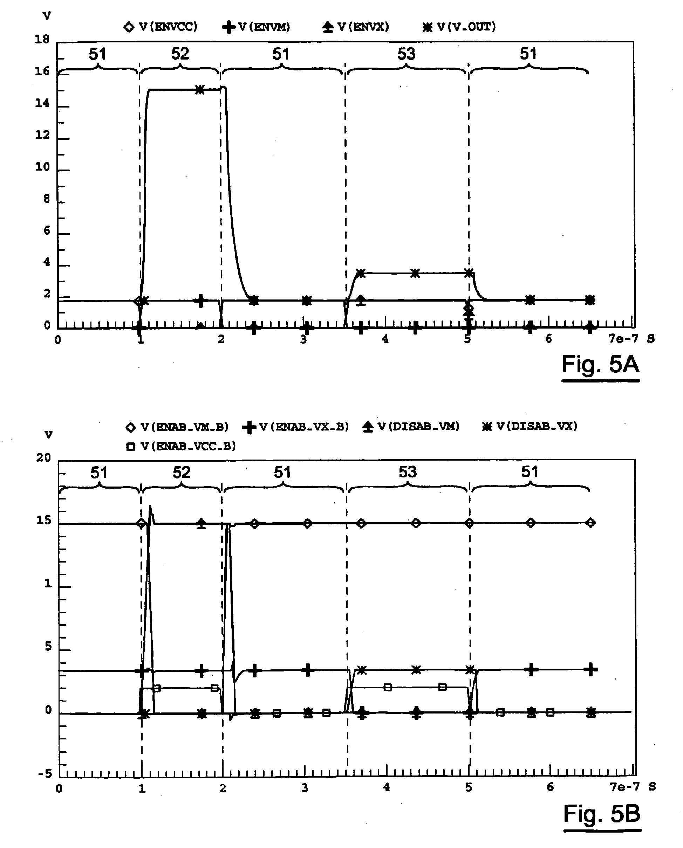

On présente désormais, en relation avec les figures 5A à 5F les courbes représentatives de la tension véhiculée par les différents signaux du circuit électronique, en fonction du temps.

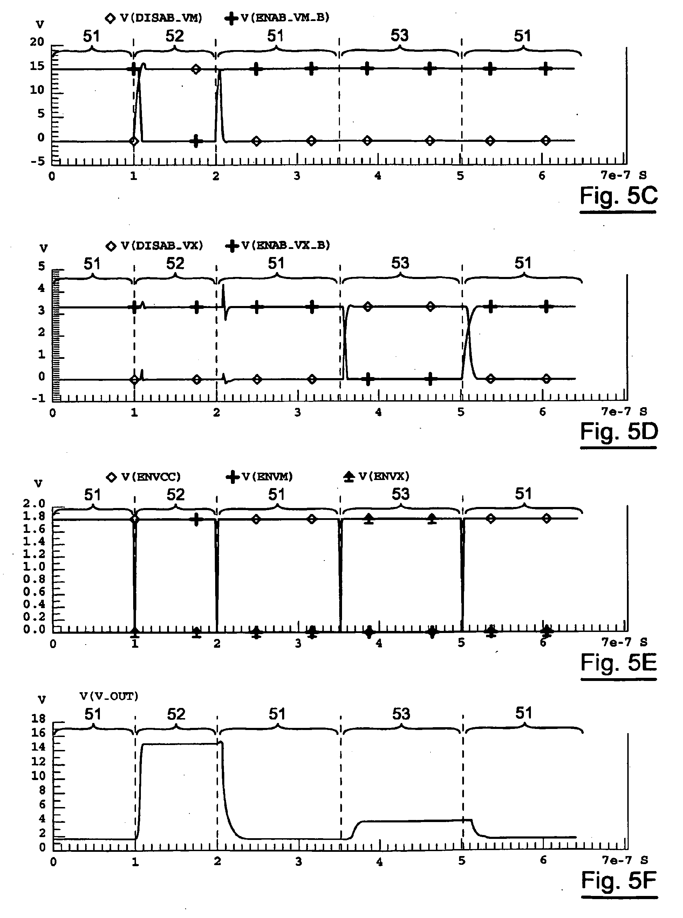

Les figures 5A, 5E, et 5F illustrent les niveaux de chacun des signaux de contrôle *envm, envx, envcc* (où le niveau haut correspond au potentiel VCC, la tension VCC alimentant tout le circuit électronique, et le niveau bas correspond au potentiel 0V), et la tension en sortie de l'aiguilleur V_out correspondante, en fonction du temps.

Les figures 5B, 5C et 5D illustrent la tension des signaux de contrôle interne correspondants *enab_vm_b, enab_vx_b, disab_vm, disab_vx*, et *enab_vcc_b* en fonction du temps.

### État initial :

Plus précisément, à l'état initial, on considère que les signaux de contrôle *envm, envx* et *envcc* sont à l'état 0 (niveau bas).

Lorsque le signal de contrôle *envm* est à l'état 0, la sortie *enab_vm_b* de la bascule haute tension *vm_latch_enab* 122 est à la tension VM, bloquant ainsi le transistor P0_VM, et la sortie *disab_vm* de la bascule haute tension *vm_latch_disab* 121 est au potentiel 0V, laissant ainsi passants les transistors P1_VX et P1_VCC.

Lorsque le signal de contrôle *envx* est à l'état 0, la sortie *enab_vx_b* de la bascule haute tension *vx_latch_enab* 132 est à la tension VX, bloquant ainsi le transistor P0_VX, et la sortie *disab_vx* de la bascule haute tension *vx_latch_disab* 131 est au potentiel 0V, laissant ainsi passants les transistors P1_VM et P0_VCC.

Lorsque le signal de contrôle *envcc* est à l'état 0, la sortie *enab_vcc_b* en sortie de l'inverseur 145 est à la tension VCC, bloquant ainsi le transistor P_Sel_VCC.

### Première branche 12 sélectionnée (référence 52 sur les figures 5A à 5F) :

Les signaux de contrôle *envm, envx* et *envcc* permettent par exemple de sélectionner la première branche 12, de sorte que la tension en sortie de l'aiguilleur V_out soit égale à VM.

Dans ce cas, le signal de contrôle *envm* est à un niveau haut (égal à VCC), tandis que les autres signaux de contrôle *envx* et *envcc* sont à un niveau bas (égal à 0).

Comme illustré en figures 5C et 5E, lorsque le signal de contrôle *envm* est à l'état 1 (soit encore au niveau haut égal à VCC), la sortie *enab_vm_b* est au potentiel 0V, laissant passant le transistor P0_VM, et la sortie *disab_vm* est à la tension VM, bloquant ainsi les transistors P1_VX et P1_VCC.

Comme le signal de contrôle *envx* est toujours à l'état 0, la sortie *enab_vx_b* est à la tension VX, bloquant ainsi le transistor P0_VX, et la sortie *disab_vx* est au potentiel 0V laissant ainsi passants les transistors P1_VM et P0_VCC.

De même, le signal de contrôle *envcc* étant toujours à l'état 0, la sortie *enab_vcc_b* est à la tension VCC, bloquant ainsi le transistor P_Sel_VCC.

En conséquence, les transistors P0_VM et P1_VM étant passants, la sortie de l'aiguilleur V_out monte à la tension VM, comme illustré en figure 5F.

On remarque également que les grilles des transistors P1_VX et P1_VCC sont au potentiel VM, bloquant ainsi ces transistors de protection et empêchant les tensions d'alimentation VX de la deuxième branche 13 et VCC de la troisième branche 14 d'être aiguillées vers la sortie de l'aiguilleur V_out.

### Deuxième branche 13 sélectionnée (référence 53 sur les figures 5A à 5F) :

Les signaux de contrôle *envm, envx* et *envcc* permettent également de sélectionner la deuxième branche 13, de sorte que la tension en sortie de l'aiguilleur V_out soit égale à VX.

Dans ce cas, le signal de contrôle *envx* est à un niveau haut (égal à VCC), tandis que les autres signaux de contrôle *envm* et *envcc* sont à un niveau bas (égal à 0).

Lorsque le signal de contrôle *envm* est à l'état 0, la sortie *enab_vm_b* est à la tension VM, bloquant ainsi le transistor P0_VM, et la sortie *disab_vm* est au potentiel 0V, laissant passants les transistors P1_VX et P1_VCC.

Comme illustré en figures 5D et 5E, lorsque le signal de contrôle *envx* est à l'état 1 (niveau haut égal à VCC), la sortie *enab_vx_b* est au potentiel 0V, laissant ainsi passant le transistor P0_VX, et la sortie *disab_vx* est à la tension VX, bloquant ainsi les transistors P1_VM et P0_VCC.

De nouveau, le signal de contrôle *envcc* étant toujours à l'état 0, la sortie *enab_vcc_b* est à la tension VCC, bloquant ainsi le transistor P_Sel_VCC.

En conséquence, les transistors P0_VX et P1_VX étant passants, la sortie de l'aiguilleur V_out monte à la tension VX, comme illustré en figure 5F.

On peut de nouveau remarquer que les grilles des transistors P1_VM et P0_VCC sont au potentiel VX, bloquant ainsi ces transistors de protection et empêchant les tensions d'alimentation VM de la première branche 12 et VCC de la troisième branche 14 d'être aiguillées vers la sortie de l'aiguilleur V_out.

### Troisième branche 14 sélectionnée (référence 51 sur les figures 5A à 5F) :

Les signaux de contrôle *envm, envx* et *envcc* permettent encore de sélectionner la troisième branche 14, de sorte que la tension en sortie de l'aiguilleur V_out soit égale à VCC.

Dans ce cas, le signal de contrôle *envcc* est à un niveau haut (égal à VCC), tandis que les autres signaux de contrôle *envm* et *envx* sont à un niveau bas (égal à 0).

De nouveau, lorsque le signal de contrôle *envm* est à l'état 0, la sortie *enab_vm_b* est à la tension VM, bloquant ainsi le transistor P0_VM, et la sortie *disab_vm* est au potentiel 0V laissant passant les transistors P1_VX et P1_VCC.

Lorsque le signal de contrôle *envx* est à l'état 0, la sortie *enab_vx_b* est à la tension VX, bloquant ainsi le transistor P0_VX, et la sortie *disab_vx* est au potentiel 0V, laissant ainsi passants les transistors P1_VM et P0_VCC.

Lorsque le signal de contrôle *envcc* est à l'état 1 (niveau haut égal à VCC) comme illustré en figure 5E, la sortie *enab_vcc_b* est à au potentiel 0V, laissant ainsi passant le transistor P_Sel_VCC.

En conséquence, les transistors P_Sel_VCC, P0_VCC et P1_VCC étant passants, la sortie de l'aiguilleur V_out monte à la tension VCC, comme illustré en figure 5F.

On peut de nouveau remarquer que les grilles des transistors P1_VM et P1_VX sont au potentiel 0V, laissant ainsi passants ces transistors de protection, mais les grilles des transistors P0_VM et P0_VX sont respectivement aux potentiels VM et VX, bloquant ces deux transistors.

Ils empêchent ainsi les tensions d'alimentation VM de la première branche 12 et VX de la deuxième branche 13 d'être aiguillées vers la sortie de l'aiguilleur V_out.

Le circuit électronique selon l'invention permet ainsi d'aiguiller une tension vers une sortie unique, en fonction de signaux de contrôle déterminant la tension à aiguiller, et donc la branche à sélectionner. La figure 5F présente ainsi la tension V_out en sortie de l'aiguilleur, correspondant aux niveaux des signaux de contrôle *envm, envx* et *envcc* en entrée, tels qu'illustrés en figure 5E.

On constate notamment que les grilles des transistors PMOS haute tension sont toujours polarisées à la bonne tension, ce qui évite la conduction inverse des transistors PMOS. Ce phénomène de conduction inverse intervient notamment lorsque le potentiel de la source d'un transistor monte à un potentiel supérieur à celui de la grille du transistor. L'invention permet donc de remédier à ce problème de conduction inverse.

On rappelle que le circuit électronique selon l'invention comprend des systèmes de retard *vm_del_enable* 124 et *vx_del_enable* 134 permettant de retarder la sélection des branches et des systèmes de retard *vm_del_disable* 123 et *vx_del_disable* 133 permettant de retarder la désélection des autres branches.

Ces systèmes de retard permettent d'éviter le passage d'un courant entre une branche nouvellement sélectionnée et la branche précédemment sélectionnée, en cours de désélection.

L'invention permet ainsi d'aiguiller plusieurs tensions vers une sortie unique en utilisant dans chacune des branches des transistors PMOS montés en série, le caisson du transistor situé à l'extrémité de la branche étant directement relié à la sortie de l'aiguilleur, et éventuellement des systèmes de retard, assurant ainsi un contrôle efficace des courants de fuite et de court-circuit et un nombre minimal de transistors.

L'invention s'applique également à des systèmes permettant d'aiguiller plus de trois tensions, en ajoutant au moins un transistor haute tension en série avec les autres transistors PMOS dans chacune des branches.

Le dispositif d'aiguillage de tension selon l'invention peut être utilisé dès que plusieurs alimentations sont nécessaires, par exemple dans les mémoires, notamment de type Flash ou EEPROM.

## Revendications

1. Dispositif d'aiguillage de tensions (11) comprenant au moins deux branches (12, 13, 14) permettant chacune d'aiguiller une tension provenant d'une alimentation (VM, VX, VCC), vers une sortie unique (V-out),
**caractérisé en ce qu'**au moins une desdites branchés, dite branche de premier type, comprend au moins deux bascules (121, 122) un inverseur (125) et au moins deux transistors en série (P0_VM, P1_VM) et au moins une autre desdites branches, dite branche de deuxième type, comprend un inverseur (145) et au moins trois transistors en série (P_sel_VCC, P0_VCC, P1_VCC)
et **en ce qu'**au moins un transistor de chacune desdites branches est un transistor de protection (P1_VM, P1_VX, P0_VCC, P1_VCC) assurant une double fonction de :
- protection de ladite alimentation ; et
- gestion d'au moins un courant de fuite, généré entre au moins deux broches dudit transistor de protection, ladite gestion est réalisée par une liaison entre le caisson dudit transistor de protection et ladite sortie unique.

2. Dispositif selon la revendication 1, **caractérisé en ce que** lesdits transistors sont de type PMOS.

3. Dispositif selon l'une quelconque des revendications 1 et 2, **caractérisé en ce que** ladite protection est assurée par positionnement dudit au moins un transistor de protection à l'extrémité de ladite branche, connectée à ladite sortie unique.

4. Dispositif selon l'une quelconque des revendications 1 à 3 **caractérisé en ce que**, ledit dispositif comprenant des moyens de sélection (envm, envx, envcc) d'une desdites branches portant la tension à aiguiller vers ladite sortie unique, au moins une desdites branches comprend des moyens de réduction d'un courant de court-circuit généré lors de ladite sélection.

5. Dispositif selon la revendication 4, **caractérisé en ce que** lesdits moyens de réduction comprennent au moins un système de retard (123, 124, 133, 134) d'au moins deux inverseurs montés en série.

6. Dispositif selon l'une quelconque des revendications 1 à 5, **caractérisé en ce que** ladite branche de premier type comprend également deux systèmes de retard (123, 124).

7. Dispositif selon l'une quelconque des revendications 1 à 6, **caractérisé en ce que** parmi lesdits au moins trois transistors de ladite branche de deuxième type (14) au moins deux assurent ladite gestion des courants de fuite (P0_VCC, P1_VCC).

8. Dispositif selon l'une quelconque des revendications 1 à 7, **caractérisé en ce que** ladite tension aiguillée par ladite branche de deuxième type provient d'une alimentation basse tension (VCC).

9. Dispositif selon l'une quelconque des revendications 4 à 8, **caractérisé en ce que**, lorsqu'une desdites branches est sélectionnée, au moins un desdits transistors de chacune des autres branches est dans un état bloqué.

10. Circuit électronique **caractérisé en ce qu'**il comprend un dispositif d'aiguillage de tensions selon l'une quelconque des revendications 1 à 9.

11. Mémoire **caractérisé en ce qu'**elle comprend un dispositif d'aiguillage de tensions selon l'une quelconque des revendications 1 à 9.

## Claims

1. A voltage switching device (11) comprising at least two branches (12, 13, 14), each of which allows a supply voltage (VM, VX, VCC) to be switched to a single output (V_out),
wherein at least one of said branches, hereinafter referred to as the first type of branch, comprises at least two level shifters (121, 122), an inverter (125) and at least two transistors in series (P0_VM, P1, VM); and at least one other of said branches, hereinafter referred to as the second type of branch, comprises an inverter (145) and at least three transistors in series (P_sel_VCC, P0_VCC, P1_VCC),
and wherein at least one transistor in each of the branches is a protective transistor (P1_VM, P1_VX, P0_VCC, P1_VCC), providing a dual function:
- protecting said supply voltage; and
- management of at least one leakage current, generated between at least two pins of said protective transistor, said management being implemented by connecting the well of said protective transistor to said single output.

2. A device as per claim 1, wherein said transistors are PMOS type transistors.

3. A device as per either of the claims 1 and 2, wherein said protection is guaranteed by the placement of said protective transistor or transistors at the end of the said branch, connected to the single output.

4. A device as per any of the claims 1 through 3, wherein said device comprises means of selecting (envm, envx, envcc) one of said branches supplying the voltage to be switched to the single output, and wherein at least one of the branches includes means of reducing a short-circuit current generated during said selection.

5. A device as per claim 4, wherein said means of reduction include at least one delay system (123, 124, 133, 134), made up of at least two inverters in series.

6. A device as per any of the claims 1 through 5, wherein said branch of the first type also comprises two delay systems (123, 124).

7. A device as per any of the claims 1 through 6, wherein at least two transistors in the series of transistors of the branch of second type ensure that leakage currents can be handled.

8. A device as per any of the claims 1 through 7, wherein said voltage switched via the branch of the second type comes from a low-voltage supply (VCC).

9. A device as per any of the claims 4 through 8, wherein at least one of the transistors in each of the other branches is blocked when any one of the branches is selected.

10. An electronic circuit **characterized in that** it comprises a voltage switching device according to any one of claims 1 to 9.

11. A memory **characterized in that** it comprises a voltage switching device according to any one of claims 1 to 9.

## Patentansprüche

1. Vorrichtung zur Leitung von Spannungen (11), die mindestens zwei Zweige (12, 13, 14) aufweist, die jeweils das Leiten einer Spannung von einer Zuführung (VM, VX, VCC) zu einem einzigen Ausgang (V_out) ermöglichen,
**dadurch gekennzeichnet, dass** mindestens einer der Zweige, der Zweig des ersten Typs genannt wird, mindestens zwei Flip-Flops (121, 122), einen Inverter (125) und mindestens zwei in Reihe geschaltete Transistoren (PO_VM, P1_VM) aufweist, und mindestens ein anderer der Zweige, der Zweig des zweiten Typs genannt wird, einen Inverter (145) und mindestens drei in Reihe geschaltete Transistoren (P_sel_VCC, P0_VCC, P1_VCC) aufweist;
und **dadurch**, dass mindestens ein Transistor von jedem der Zweige ein Schutztransistor (P1_VM, P1_VX, P0_VCC, P1_VCC) ist, der die folgende Doppelfunktion gewährleistet:
- Schutz der Zuführung; und
- Verwaltung von mindestens einem Ableitstrom, der zwischen mindestens zwei Pins des Schutztransistors erzeugt wird, wobei die Verwaltung durch eine Verbindung zwischen dem Gehäuse des Schutztransistors und dem einzigen Ausgang ausgeführt wird.

2. Vorrichtung nach Anspruch 1, **dadurch gekennzeichnet, dass** die Transistoren vom PMOS-Typ sind.

3. Vorrichtung nach einem der Ansprüche 1 und 2, **dadurch gekennzeichnet, dass** der Schutz durch Positionieren des mindestens einen Schutztransistors am Ende des Zweigs gewährleistet wird, der mit dem einzigen Ausgang verbunden ist.

4. Vorrichtung nach einem der Ansprüche 1 bis 3, **dadurch gekennzeichnet, dass** die Vorrichtung Mittel zum Auswählen (envm, envx, envcc) eines der Zweige aufweist, der die zu leitende Spannung zum einzigen Ausgang führt, wobei mindestens einer der Zweige Mittel zur Verringerung eines Kurzschlussstroms umfasst, der während der Auswahl erzeugt wird.

5. Vorrichtung nach Anspruch 4, **dadurch gekennzeichnet, dass** die Verringerungsmittel mindestens ein Verzögerungssystem (123, 124, 133, 134) aufweisen, das aus mindestens zwei in Reihe geschalteten Invertern besteht.

6. Vorrichtung nach einem der Ansprüche 1 bis 5, **dadurch gekennzeichnet, dass** der Zweig des ersten Typs ebenfalls zwei Verzögerungssysteme (123, 124) umfasst.

7. Vorrichtung nach einem der Ansprüche 1 bis 6, **dadurch gekennzeichnet, dass** unter den mindestens drei Transistoren des Zweigs des zweiten Typs (14) mindestens zwei die Verwaltung der Ableitströme (P0_VCC, P1_VCC) gewährleisten.

8. Vorrichtung nach einem der Ansprüche 1 bis 7, **dadurch gekennzeichnet, dass** die durch den Zweig des zweiten Typs geleitete Spannung von einer Niederspannungszuführung (VCC) stammt.

9. Vorrichtung nach einem der Ansprüche 4 bis 8, **dadurch gekennzeichnet, dass**, wenn einer der Zweige ausgewählt wird, mindestens einer der Transistoren von jedem der anderen Zweige in einem gesperrten Zustand ist.

10. Elektronische Schaltung, **dadurch gekennzeichnet, dass** sie eine Vorrichtung zum Leiten von Spannungen nach einem der Ansprüche 1 bis 9 umfasst.

11. Speicher, **dadurch gekennzeichnet, dass** er eine Vorrichtung zum Leiten von Spannungen nach einem der Ansprüche 1 bis 9 umfasst.
